# EUROPEAN PATENT APPLICATION

(11) **EP 0 863 545 A2**
(43) Date of publication of application: **09.09.1998**
(21) Application number: 98301666.8
(22) Date of filing: 06.03.1998
(51) Int. Cl.: H01L 21/68

(54) **Monocrystalline ceramic electrostatic chuck**

(30) Priority: 06.03.1997 US 812194; 29.08.1997 US 920423
(71) Applicant: Applied Materials, Inc., Santa Clara, California 95054 (US)
(72) Inventor: Herchen, Harald, San Jose, California 95135 (US)
(74) Representative: Bayliss, Geoffrey Cyril

(57) **Abstract**

An electrostatic chuck **20** for holding a substrate **40** in a process chamber **70**, comprises a monocrystalline ceramic monolith **25** with an electrode **45** embedded therein for electrostatically holding the substrate **40** upon application of a voltage thereto. The ceramic monolith **25** is made from a single piece of monocrystalline ceramic formed by a melt forming process, or a plurality of monocrystalline ceramic plates **225** bonded to one another. In another embodiment, the invention is directed to an electrostatic chuck comprising a monocrystalline ceramic layer **235** covering a mesh electrode **240** on an underlying dielectric layer **245**. An electrical connector **50** extends through the monocrystalline ceramic monolith **25** or the underlying dielectric layer **245** to supply a voltage to the electrode **45**. Preferably, the monocrystalline ceramic monolithic structure **25** and the monocrystalline ceramic layer **235** comprise monocrystalline sapphire and the electrodes **45** comprise a refractory metal. Alternative cooling systems are also described.

## Description

The present invention relates to electrostatic chucks useful for holding substrates during processing.

Electrostatic chucks are used to hold semiconductor substrates, such as silicon wafers, in a process chamber. A typical electrostatic chuck comprises an electrode covered by a dielectric layer. In monopolar chucks, an attractive electrostatic force is generated when the electrode of the chuck is electrically biased by a voltage and an electrically charged plasma in the chamber induces electrostatic charge in the substrate. A bipolar chuck comprises bipolar electrodes that are electrically biased relative to one another to generate the electrostatic attractive force.

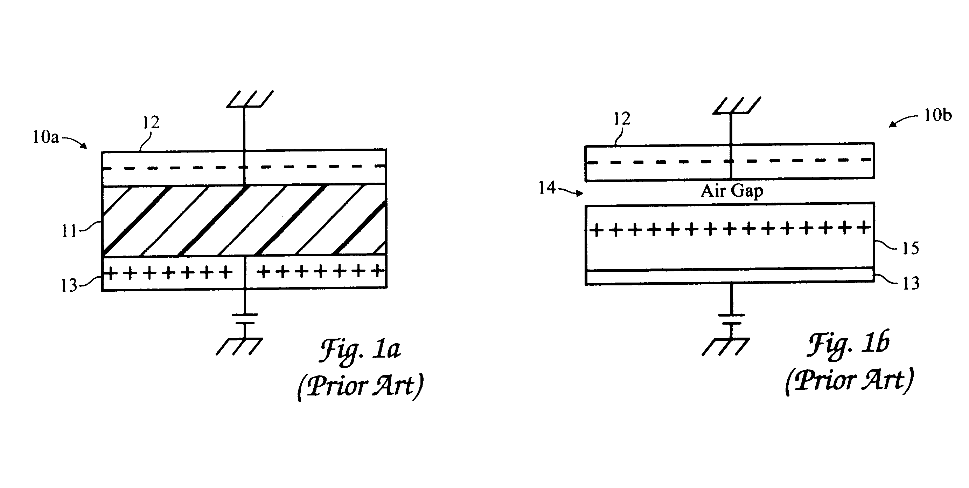

The electrostatic attractive force generated by electrostatic chucks can also be of different types. As schematically illustrated in Figure 1a, a chuck **10a** having a dielectric layer **11** with a high electrical resistance results in coulombic electrostatic forces where opposing electrostatic charges accumulate in the substrate **12** and in the electrode **13** of the chuck. The coulombic electrostatic force is described by the equation:$\text{F} \text{=} \frac{\text{1}}{\text{2}} {\text{ε}}_{\text{0}} {\text{ε}}_{\text{r}} {\left(\frac{\text{V}}{\text{t}}\right)}^{2} \text{A}$ where ε₀ and εᵣ are the dielectric constant of vacuum and relative dielectric constant of the dielectric layer **11**, respectively, *V* is the voltage applied to the electrode **13**, A is the area of the electrode, and t is the thickness of the dielectric layer.

With reference to Figure 1b, Johnsen-Rahbek electrostatic attraction forces occur in the chuck **10b** when an air-gap or interface **14** between a low resistance or leaky dielectric layer **15** and the substrate **12**, has an interfacial contact resistance much greater than the resistance of the dielectric layer **15**, i.e., when the resistance of the dielectric layer **15** is typically from about 10¹¹ to about 10¹⁴ Ω/cm. Free electrostatic charge drifts through the dielectric layer **15** in the applied electric field, and accumulates at the interface of the dielectric layer **15** and the substrate **12**. The charge accumulated at the interface generates a potential drop represented by the equation:$\text{F} \text{=} \frac{\text{1}}{\text{2}} {\text{ε}}_{\text{0}} {\left(\frac{\text{V}}{\text{δ}}\right)}^{2} \text{A}$ where δ denotes the contact resistance of the interface **14** between the substrate **12** and the low resistance dielectric layer **15**. The Johnsen-Rahbek electrostatic attractive force is typically higher than that provided by coulombic forces, because polarization in the dielectric layer **15**, and free charges accumulated at the interface **14** combine to enhance electrostatic force. This provides a stronger electrostatic force that more securely holds the substrate **12** onto the chuck and also improves thermal transfer rates at the interface. Also, the lower voltages used in these chucks reduce the possibility of charge-up damage to active devices on the substrate **12.**

The dielectric layers **11, 15** covering the electrode **13** of these chucks typically comprise a thin polymer film, such as polyimide, adhered to the electrode, as for example disclosed in U.S. Patent No. 08/381,786, entitled "Electrostatic Chuck with Conformal Insulator Film," filed on January 31, 1995, to Shamouilian, et al., which is incorporated herein by reference. However, the substrate held on the chuck often breaks or chips to form fragments having sharp edges that puncture the polymer film and expose the electrode. Exposure of the electrode at even a single pinhole in the dielectric layer can cause arcing between the electrode and plasma, and require replacement of the entire chuck. Polymers also have a limited lifetime in erosive process environments, such as processes using oxygen-containing gases and plasmas. Also, polymers or adhesives used to bond the polymer films to the chuck often cannot operate at elevated temperatures exceeding 1000°C.

Polycrystalline ceramics have also been used to form the dielectric layer to provide increased puncture resistance and higher temperature performance, as for example, described in U.S. Patent No. 5,280,156 to Niori; U.S. Patent No. 4,480,284; Watanabe, et al., in "Relationship between Electrical Resistivity and Electrostatic Force of Alumina Electrostatic Chuck," Jpn. J. Appl. Phys., Vol. 32, Part 1, No. 2, (1993); or "Resistivity and Microstructure of Alumina Ceramics Added with TiO₂ Fired in Reducing Atmosphere," J. of the Am. Cer. Soc. of Japan Intl. Ed., Vol. 101, No. 10, pp. 1107-1114 (July 1993); all of which are incorporated herein by reference. The ceramic dielectric layers typically comprise a low conductivity polycrystalline ceramic, such as a mixture of Al₂O₃ and TiO₂, or BaTiO₃. However, polycrystalline ceramics such as Al₂O₃ doped with TiO₂ often have an electrical resistance that changes with temperature, and can exhibit low or insufficient electrical resistance at high temperatures. Also, polycrystalline ceramics comprise small grains or crystals that typically have a diameter of 0.1 to 50 microns, and have grain boundaries containing a mixture of glassy materials that hold the grains together. When such ceramic layers are exposed to erosive environments, such as a fluorine containing plasmas, the plasma etches away the grain boundary regions causing the ceramic grains to loosen and flake off during processing of the substrate. Abrasion of the substrate against the chuck can also cause ceramic grains to flake off the chuck. These particulate ceramic grains contaminate the substrate and/or process chamber and reduce the yields of integrated circuit chips from the substrate.

Dielectric layers comprising a thin wafer of monocrystalline ceramic that is made of a few, relatively large, ceramic crystals have also been used to cover the electrode. For example, U.S. Patent Application No. 5,413,360 to Atari, et al., describes an electrostatic chuck consisting of a monocrystalline ceramic wafer covering an electrode on a dielectric plate. Atari teaches that a bonding agent, or a high temperature joining method, is used to join the monocrystalline ceramic wafer to the electrode of the chuck. In another example, U.S. Patent No. 5,535,090 to Sherman, filed March 3, 1994, discloses an electrostatic chuck comprising small segments of monocrystalline ceramic wafers adhered to the surface of an electrode using a high temperature vacuum braze with a suitable brazing alloy. For example, a platinum layer can be sputtered onto the monocrystalline ceramic layer and a platinum paste used to adhere the monocrystalline ceramic layer to the metal electrode.

One problem with such chucks arises from their structure, which typically comprises a single relatively thin monocrystalline ceramic wafer bonded to the metal electrode with a layer of bonding material therebetween, and supported by a metal or dielectric plate made from another material. During the bonding process or during use of the chuck in an erosive process environment, the thermal expansion mismatch between the monocrystalline ceramic wafer and the electrode can result in failure of the bond. Also, the bonding material is typically a metal based material that thermally or chemically degrades during use of the chuck in reactive processes, causing failure of the chuck and movement or misalignment of the substrate during processing. The thin monocrystalline ceramic wafer and electrode can also separate from the supporting dielectric or metal plate at high temperatures due to stresses arising from the thermal expansion coefficient mismatches. Another problem arises because grooves, channels, and other hollow spaces which are used to hold coolant or to supply helium gas to the interface below the substrate, are difficult to form in the brittle, hard, and thin monocrystalline ceramic layers. During the series of machining or drilling steps that are used to form these hollow shapes, the brittle layers often crack or chip resulting in loss of the chuck. It is also difficult to precisely machine fine holes or grooves in the monocrystalline ceramic wafer.

Yet another problem with such conventional chucks arises from the method of fabrication of the monocrystalline ceramic wafers. In one method, the Czochralski-type method, large crystals of monocrystalline ceramic are drawn from molten alumina using a seeding crystal mounted on a die. The drawn out material cools and solidifies to form a column of large and oriented crystals. Thereafter, the column is sliced to form monocrystalline ceramic wafers. Another method commonly known as the EFG process (edge-defined, film fed, growth process) is taught for example, by U.S. Patent Nos. 3,701,636 and 3,915,662 to La Bella, et al., both of which are incorporated herein by reference. In these methods, a single crystal of monocrystalline ceramic is drawn from molten alumina, using a die such as an annular ring contacting the molten alumina in a capillary tube. The molten alumina rises in the tube via capillary forces and the die provides a seeding surface from which the monocrystalline ceramic crystal is grown. However, the size of the monocrystalline ceramic crystal grown by these methods is restricted by the dimensions of the size of the die opening, preventing growth of large monocrystalline ceramic crystals need for large diameter chucks. The fabrication methods can also produce crystals having relatively small grains and with facet defects. Also, the drawn out crystal can twist and turn during the drawing out process to provide a disoriented and faceted crystalline structure.

It is desirable to have a chuck made of monocrystalline ceramic that exhibits reduced thermal expansion mismatch, low rates of erosion in plasma environments, and reduced particulate generation during use in semiconductor processing. It is also desirable for the monocrystalline ceramic used in the chuck to provide stable and reliable electrical properties at high operating temperatures, preferably exceeding about 1000°C. It is further desirable to have predefined shapes of grooves, slots and channels for holding cooling fluid or helium gas in the body of the chuck to regulate the temperatures of the substrate and chuck.

An electrostatic chuck of the present invention comprises monocrystalline ceramic material that exhibits reduced erosion, is resistant to particle generation, and provides reliable and stable electrical properties at high operating temperatures. The electrostatic chuck preferably comprises a monocrystalline ceramic monolith having a receiving surface for receiving a substrate. An electrode is embedded in the monocrystalline ceramic monolith for generating an electrostatic force for electrostatically holding the substrate. An electrical connector extending through the monolith is used to supply a voltage to operate the electrode. Preferably, the monocrystalline ceramic comprises large crystals having a diameter of about 0.5 to about 10 cm, which are substantially oriented to one another in a single crystallographic direction. The electrode of the chuck comprises a pattern of lattice defects induced in the ceramic plates, a pattern of dopant in the ceramic plates, or an electrode made of conducting metal. The monocrystalline ceramic chuck can be operated at elevated temperatures with little or no contamination of the substrate.

Another preferred version of the electrostatic chuck comprises a monocrystalline ceramic layer covering a mesh electrode on an underlying dielectric layer. The monocrystalline ceramic comprises large crystals that are substantially oriented to one another, and that have integral bonding interconnects that extend through apertures in the mesh electrode to bond directly to the underlying dielectric layer. Preferably, the monocrystalline ceramic layer is bonded directly to the underlying dielectric layer substantially without any adhesive layer. More preferably, one or more of the monocrystalline ceramic layer and underlying dielectric layer, are made from single crystal of sapphire.

Yet another version of the electrostatic chuck, useful for regulating the temperature of a substrate, comprises a dielectric member having an electrode embedded therein and a receiving surface for receiving the substrate. The dielectric member comprises a fluid conduit for circulating heat transfer fluid in the chuck. Preferably, the fluid conduit comprises first passageways at a distance D₁ from the receiving surface, and second passageways at a distance D₂ from the receiving surface, the distance D₁ being greater than the distance D₂. Preferable, the first passageways are adjacent to a fluid inlet that supplies heat transfer fluid to the conduit and the second passageways are adjacent to a fluid outlet that removes the heat transfer fluid. The distance D₁ is sufficiently greater than the distance D₂ to compensate for a rise in temperature or cooling of the heat transfer fluid as it circulates through the chuck. In one version, the fluid conduit comprises a rectangular cross-section having a central axis that is at an angle to the receiving surface. In another version, the fluid conduits comprise a helical conduit rising toward the receiving surface from the fluid inlet to the fluid outlet. In yet another version, circumferential inner and outer edges, the inner edge being at a distance D_{IN} from the receiving surface, and the outer edge being at a distance D_{OT} from the receiving surface, the difference between the distance D_{IN} and the distance D_{OT} selected to maintain a substantially uniform rate of thermal transfer across the receiving surface of the chuck.

The electrostatic chuck can be fabricated by a variety of methods, including bonding a plurality of monocrystalline ceramic plates to one another to form a unitary monolithic structure, or directional solidification of molten ceramic, or moving a capillary tube method to seed a monocrystalline layer over an electrode. The first method uses a plurality of monocrystalline ceramic plates, such as sapphire, and forms an electrode on one or more of the monocrystalline ceramic plates. The monocrystalline ceramic plates are bonded to one another to form a monolithic structure having the electrode embedded therein. The monocrystalline ceramic plates can be bonded to one another by applying a bonding compound comprising aluminum oxide to the monocrystalline ceramic plates and heat treating the bonding compound. Preferably, the bonding compound comprises an eutectic mixture of aluminum oxide and eutectic component, the eutectic mixture having an melting temperature of less than about 2000°C.

In another preferred method of forming the electrostatic chuck, ceramic material is melted in a mold to form molten ceramic, the mold having an internal shape of an electrostatic chuck. One or more of electrode forms, channel forms, and conduit forms are held in the molten ceramic, and a seeding crystal is maintained in contact with the molten ceramic. The molten ceramic is directionally cooled to form monocrystalline ceramic comprising large crystals substantially oriented to one another, and having the electrode, channel forms, or conduit forms embedded therein. One or more of the electrode, channel, or conduit shaping forms in the monocrystalline ceramic are then suitably treated, for example, in an oxidation heat treatment or wet chemical etching process, to form a monocrystalline ceramic monolith having an electrode, and channels or conduits for holding heat transfer fluid or gas, respectively. The method provides an intermediate product comprising a unitary monolithic monocrystalline ceramic having embedded therein one or more chemically erodible forms that are shaped to form channels and conduits.

In another preferred method of forming the electrostatic chuck, a ceramic material is melted in a melt reservoir to form a molten ceramic. A capillary tube is positioned in the melt reservoir, the capillary tube comprising an inlet in the molten ceramic of the melt reservoir, and an outlet adjacent to a workpiece surface (such as a mesh electrode held on a dielectric layer). The outlet comprises a leading edge having a seeding surface and a first height, and a trailing edge having a second height smaller than the first height. The outlet of the capillary tube is moved across the workpiece surface so that the leading edge of the capillary tube moves ahead of the trailing edge, to deposit a molten ceramic layer on the workpiece surface. The molten ceramic material is drawn through the capillary tube and seeded by a seeding crystal on the seeding surface of the leading edge. The molten ceramic layer has a thickness, *t*, substantially controlled by the difference in first and second heights. Upon cooling, the seeded molten ceramic layer forms a monocrystalline ceramic layer comprising large crystals substantially oriented to one another. Preferably, the capillary tube and the workpiece surface are continuously heated during deposition of the monocrystalline ceramic layer.

These features, aspects, and advantages of the present invention will become better understood with regard to the following description, appended claims, and accompanying drawings which illustrate examples of the invention, where:
Figure 1a (Prior Art) is a schematic view of an electrostatic chuck that operates using coulombic electrostatic forces;
Figure 1b (Prior Art) is a schematic view of an electrostatic chuck that operates using Johnsen-Rahbek electrostatic forces;
Figure 2a is a schematic sectional side view of an embodiment of an electrostatic chuck of the present invention;
Figure 2b is a schematic sectional side view of another embodiment of an electrostatic chuck of the present invention;
Figure 3 is a schematic sectional side view of a process chamber comprising a monopolar chuck of the present invention;
Figure 4 is a schematic sectional side view of a process chamber comprising a bipolar chuck of the present invention;
Figure 5a to 5e are schematic sectional views showing preferred fluid conduit arrangements of the present invention;
Figure 6a to 6d are schematic sectional views showing the successive steps used to fabricate the electrostatic chuck of Figure 2a using directional solidification of a molten ceramic in a tank;

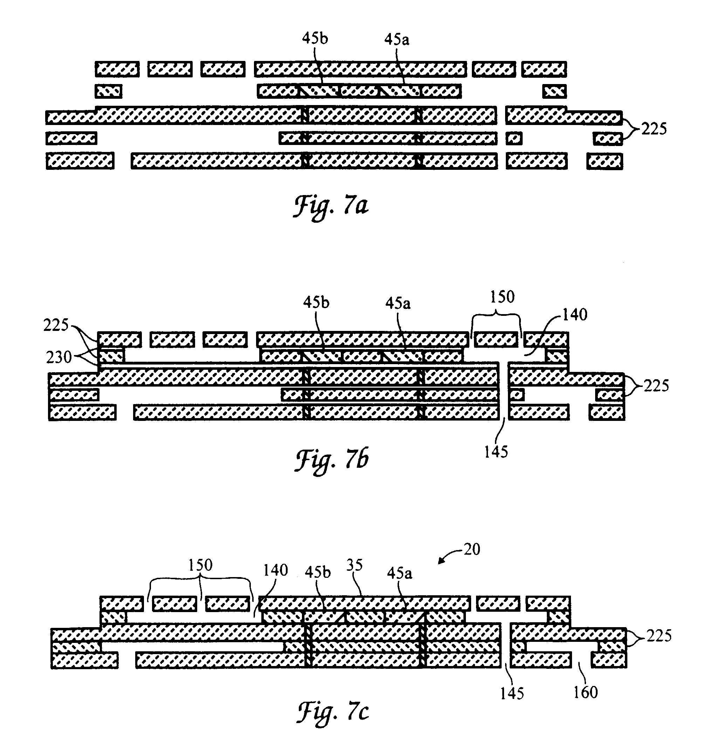

Figure 7a to 7c are exploded schematic sectional views of an assembly of precut monocrystalline ceramic plates and electrodes used to form the electrostatic chuck of Figure 2b;
Figure 8a is a schematic sectional side view of an embodiment of an electrostatic chuck comprising a monocrystalline ceramic layer covering a mesh electrode on an underlying dielectric layer; and
Figure 8b is a schematic sectional side view of an apparatus suitable for forming the electrostatic chuck of Figure 8a.

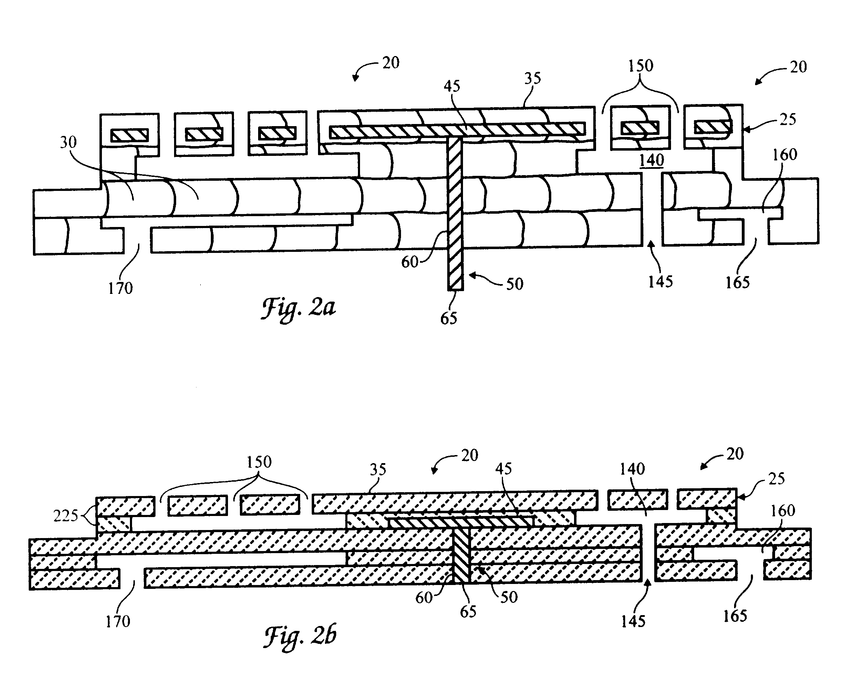

The present invention relates to an electrostatic chuck **20** comprising a unitary structure of a monocrystalline ceramic monolith **25** which comprises relatively large ceramic crystals **30** that are oriented to one another in a single crystallographic direction, as schematically represented in Figure 2a. The electrostatic chuck **20** of monocrystalline ceramic material comprises a receiving surface **35** for receiving a substrate **40**, and one or more electrodes **45** embedded therein and below the receiving surface. As shown in Figure 2a, the electrostatic chuck **20** electrostatically holds the substrate **40** to the receiving surface **35** upon application of a voltage to the electrode **45** via an electrical connector **50** that extends through the monolithic structure **25**.

The monocrystalline ceramic monolith **25** provides a unitary block of a chemically homogeneous composition that has several advantages in integrated circuit fabrication. The term "monocrystalline" which commonly refers to a single crystal material, is used here to denotes material that comprises a few (typically 10 or fewer) large ceramic crystals **30** that are oriented in the same crystallographic direction, i.e., that have crystallographic planes with miller indices that are aligned to one another. The large crystals **30** of the monocrystalline ceramic typically have an average diameter of about 0.5 to about 10 cm, and more typically from 1 to 5 cm. In contrast, conventional polycrystalline ceramic materials have small grains or crystals with diameters on the order of 0.1 micron to 50 micron, which is smaller by a factor of at least about 10⁵ to about 10⁷. The large ceramic crystals **30** in the monolithic structure **25** are oriented in substantially the same single crystallographic direction, and provide exposed surfaces having little or no impurity or glassy grain boundary regions that can erode rapidly in erosive halogen-containing environments as in small grains and crystals. The continuously homogeneous and uniform crystallographic structure of the receiving surface **35** of the monolith **25** exhibits reduced erosion or particulate generation in erosive environments and provides a relatively constant electrical resistance that does not change at higher temperatures, unlike the receiving surfaces of polycrystalline ceramic chucks.

The highly oriented crystals of the monocrystalline ceramic monolith **25** have a resistivity sufficiently high to electrically insulate the electrode **45**. The resistivity of the monolith **25** is preferably from about 1 x 10⁸ to about 1 x l0²⁰ Ω/cm, and more preferably from about 1 x 10¹¹ to about 1 x 10¹³ Ω/cm; and is tailored to provide a resistance suitable for forming either a coulombic electrostatic chuck (high resistance) or Johnsen-Rahbek electrostatic chuck (low resistance). The monolith **25** reduces particle generation during processing, provides excellent erosion resistance in erosive halogen-containing plasma environments, and exhibits consistent electrical resistance values at high temperatures, due to the presence of the large ceramic crystals. Suitable monocrystalline ceramic materials include monocrystalline Al₂O₃, AIN, BaTiO₃, BeO, BN, CaO, LaB₆, MgO, MoSi₂, Si₃N₄, SiO₂, Ta₂O₅, TiB₂, TiN, TiO₂, TiSi₂ VB₂, W₂B₃, WSi₂, ZrB₂, or ZrO₂. Preferably, the ceramic monolith **25** comprises monocrystalline sapphire which is a single crystal form of alumina that exhibits excellent chemical and erosion resistance in erosive environments, particularly halogen plasma environments. Monocrystalline sapphire also has a very high melting temperature that allows high temperature use at temperatures exceeding 1000°C and often even exceeding 2000°C. The ceramic monolith **25** can also be mixed with suitable dopants to provide the desired electrical properties such as resistivity and dielectric breakdown strength. For example, whereas pure sapphire has a resistivity on the order of 1 x 10¹⁴ Ω/cm, sapphire can be mixed with 1 to 3 wt% TiO₂ to provide a lower resistivity on the order of 1 x 10¹¹ to 1 x 10¹³ Ω/cm, which is more suitable for use in Johnsen-Rahbek-type electrostatic chucks.

The electrode **45** of the electrostatic chuck **20** comprises one of a pattern of dopant material, a pattern of lattice defects, or a metal structure embedded in the ceramic monolith **25**. Suitable metal electrodes **45** can be made from copper, nickel, chromium, aluminum, molybdenum, and combinations thereof. In a preferred version, the electrode **45** comprises a refractory metal having a melting point of at least about 2200°C to facilitate fabrication of the electrostatic chuck **20**, the thickness of the electrode being from about 1 µm to about 100 µm, and more typically from 1 µm to 50 µm. For a substrate **40** having a diameter of 200 to 300 mm (6 to 8 inches), the electrode **45** typically covers a total area of about 7,000 to about 70,000 sq. mm. Preferably, the electrode **45** comprises small apertures that are sized (i) sufficiently small to allow the electrode to generate a uniform electrostatic field for holding the substrate **40** upon application of a voltage thereto, and (ii) sufficiently large to allow the monocrystalline ceramic monolith **25** to form a strong and cohesive structure joined by interconnects extending through the apertures. Electrical connectors **50** that are used to electrically connect the electrode **45** to a chucking voltage supply **55**, comprise an electrical lead **60** that extends through the ceramic monolith **25** and an electrical contact **65** at the end of the lead. Typically, the length of the electrical lead **60** is from about 10 mm to about 50 mm, and the width of the electrical lead is from about 0.2 mm to about 10 mm.

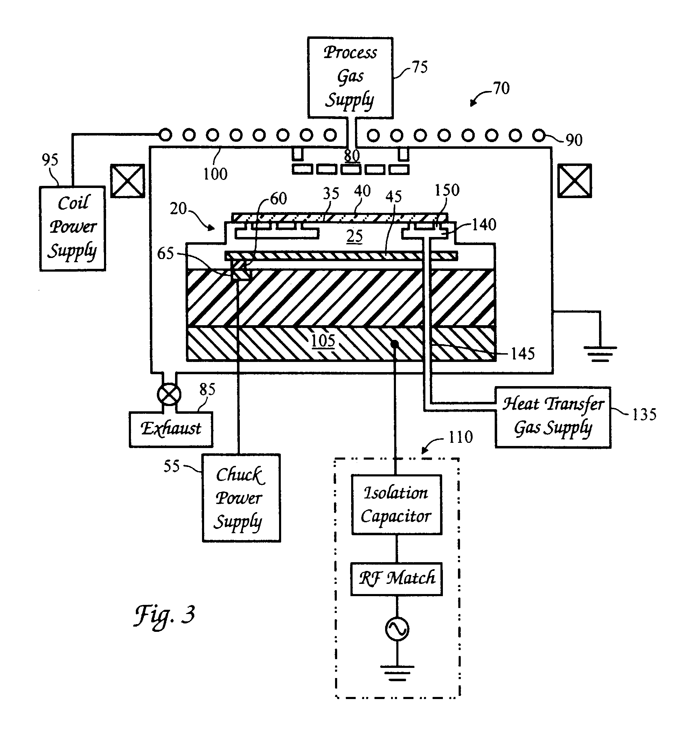

With reference to Figure 3, operation of the electrostatic chuck **20** of the present invention having a monopolar electrode **45** will be described in the context of holding semiconductor substrates in a plasma process chamber **70**. The process chamber **70** illustrated in Figure 3 represents a CENTURA 5200 oxide etch chamber commercially available from Applied Materials Inc., Santa Clara, California, as described in commonly assigned U.S. Patent Application No. 07/941,507, filed on September 8, 1992, which is incorporated herein by reference. The process chamber **70** typically includes a process gas supply **75** for introducing process gas into the process chamber via a gas distributor **80**, and a throttled exhaust 85 for exhausting gaseous byproducts from the process chamber. A plasma is formed from the process gas using a plasma generator that couples an electric field into the process chamber **70**. The plasma generator can comprise an inductor coil **90** capable of forming an inductive electric field in the process chamber **70** when powered by a coil power supply **95**. Alternatively, the process chamber **70** can include process electrodes **100, 105** that are used to generate a capacitive electric field in the process chamber **70** when powered by a process electrode power supply **110.** The process electrodes **100** can be the same electrode as the electrode **45** in the chuck **20** (not shown) or a separate electrode below the electrostatic chuck as shown in Figure 3. The capacitive electric field formed by the electrodes **100, 105** is perpendicular to the plane of the substrate **40** and accelerates inductively formed plasma species toward the substrate **40**. The frequency of the voltage applied to the process electrodes **100, 105**, and/or the inductor coil **90** is in the RF range, typically from about 50 kHz to about 60 MHZ, and more typically about 13.56 MHZ. The power of the RF voltage applied to the coil **90** or process electrodes **100, 105** is typically from about 100 to about 5000 Watts. A combination of both inductor coils **90** and process electrodes **100, 105** is preferred to provide control of both the plasma density and the plasma energy of the plasma ions.

In operation the process chamber **70** is evacuated and maintained at a subatmospheric pressure and a robot arm (not shown) transports a substrate **40** from a load-lock transfer chamber (also at subatmospheric pressure) through a slit valve and into the process chamber **70**. The robot arm places the substrate **40** on the tips of lift fingers (not shown) that are elevated by the pneumatic lift mechanism to extend about 2 to 5 centimeters above the receiving surface **35** of the electrostatic chuck **20**. The pneumatic mechanism lowers the substrate **40** onto the receiving surface **35**, and the electrode **45** of the electrostatic chuck **20** is electrically biased with respect to the substrate by the chuck voltage supply **55**. The voltage applied to the monopolar electrode **45** shown in Figure 3 causes electrostatic charge to accumulate in the electrode or in the monocrystalline ceramic material covering the electrode. The plasma in the process chamber **70** provides electrically charged species having opposing polarity which accumulate in the substrate **40**. The accumulated opposing electrostatic charges result in an attractive electrostatic force that electrostatically holds the substrate **40** to the electrostatic chuck **20**. On completion of processing, the substrate **40** is electrically decoupled or dechucked from the electrostatic chuck **20** by dissipating the residual electrical charges holding the substrate onto the electrostatic chuck after the voltage to the electrode **45** is turned off. The pneumatic lifting apparatus then raises the lift pins which lift the substrate **40** to allow the substrate to be removed by the robotic arm. Typically, the chucking voltage supply **55** is turned off, and the chucking electrode **45** is connected to ground to remove any accumulated charge. The substrate **40** can be electrically grounded by contacting it with a grounded conductor or by forming a plasma at a reduced power level to provide an electrically conductive path from the substrate to grounded walls of the process chamber **70**.

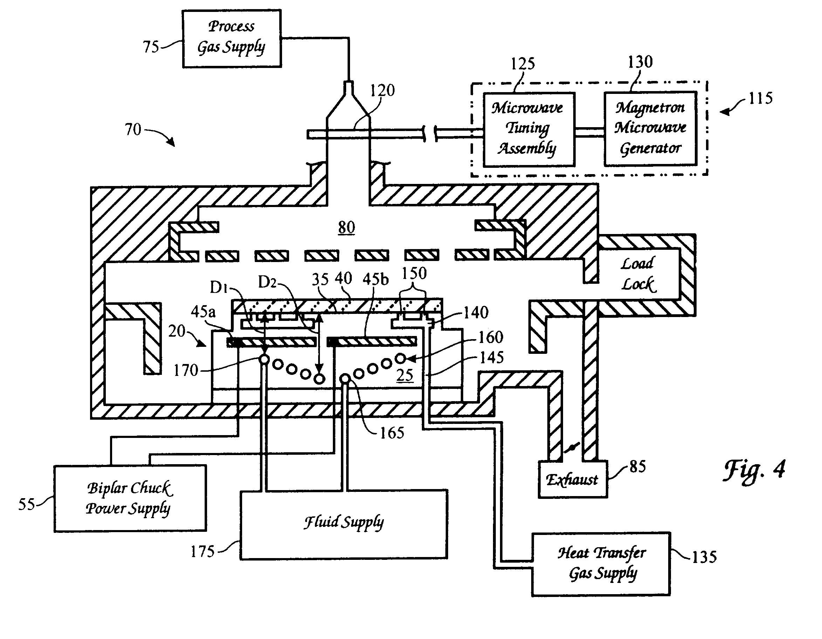

Another example of a process chamber **70** that can use the present electrostatic chuck **20**, as illustrated in Figure 4, comprises an RPS process chamber, also commercially available from Applied Materials. In this process chamber **70**, the plasma is generated using a microwave generator assembly **115** comprising a microwave applicator **120**, a microwave tuning assembly **125**, and a magnetron microwave generator **130**. A suitable microwave applicator **120** comprises a microwave waveguide positioned in a remote chamber in a flow path of the process gas as described in Applied Materials U.S. Patent Application No. 08/499,984, by Herchen, et al., entitled "MICROWAVE PLASMA BASED APPLICATOR," filed on July 10, 1995, which is incorporated herein by reference. The electrostatic chuck **20** illustrated in this process chamber **70** comprises bipolar electrodes **45a, 45b** that includes at least two substantially coplanar electrodes that generate substantially equivalent electrostatic clamping forces. The bipolar electrodes **45a, 45b** can form opposing semicircles, or inner and outer rings of electrodes with electrical isolation voids therebetween. The bipolar electrodes **45a, 45b** are operated by application of a differential electrical potential to the electrodes that induces opposing electrostatic charges in the substrate **40** to electrostatically hold the substrate to the electrostatic chuck **20**.

In a preferred embodiment, a heat transfer gas supply **135** provides heat transfer gas to the receiving surface **35** of the electrostatic chuck **20** to control the temperature of the substrate **40**. In this version, the ceramic monolith **25** comprises a gas channel **140** for holding heat transfer gas in the electrostatic chuck **20**, a gas feed **145** for providing heat transfer gas to the gas channel, and gas vents **150** extending from the channel to the receiving surface **35** for providing heat transfer gas to the receiving surface **35** below the substrate **40**. During operation, the heat transfer gas flows through the gas feed **145**, into the gas channel **140**, and out the gas vents **150**, exiting below the receiving surface **35**. The substrate **40** covers and seals the gas vents **150** on the receiving surface **35** to reduce leakage of heat transfer gas from below the substrate **40**. The heat transfer gas provides efficient heat transfer rates between the substrate **40** and the electrostatic chuck **20** to maintain the substrate at constant temperatures. Typically, the heat transfer gas is an inert gas such as helium or argon supplied at a pressure of from about 5 to about 30 Torr.

In another aspect of the present invention, illustrated schematically in Figure 4, a fluid system is used to regulate the temperature of the electrostatic chuck **20** and the substrate **40**. It should be noted that the fluid system can be used in any support for holding the substrate **40,** and should not be limited to use in electrostatic chucks **20** comprising monocrystalline ceramic material, which are used only to provide illustrative examples of this aspect of the present invention. The fluid system comprises (i) a fluid conduit **160** for holding or circulating heat transfer fluid below the receiving surface **35** of the electrostatic chuck **20**, (ii) a fluid inlet **165** for supplying heat transfer fluid to the conduit **160**, and (iii) a fluid outlet **170** for removing or exhausting the heat transfer fluid from the electrostatic chuck **20**. Preferably, the fluid conduit **160** is embedded in the electrostatic chuck **20** to provide more control over the temperature of the electrostatic chuck **20,** particularly when the electrostatic chuck is made of ceramic material having a low thermal conductance, such as aluminum oxide or sapphire. During operation, a fluid supply **175** supplies cooled or heated fluid to the fluid inlet **165** of the fluid conduit **160**. The fluid is pumped into the fluid inlet **165** circulates through the fluid conduit **160** to heat or cool the electrostatic chuck **20** (depending on the difference in temperature between the fluid and the electrostatic chuck), and flows out from the fluid outlet **170**. By virtue of being inside the electrostatic chuck **20**, the fluid conduit 160 provides lower temperature adjustment response times and higher heat transfer rates than conventional fluid systems in which a fluid is used to control the temperature of a separate metal base below the electrostatic chuck, where there are more thermal impedances between the heat sink of the base and the substrate.

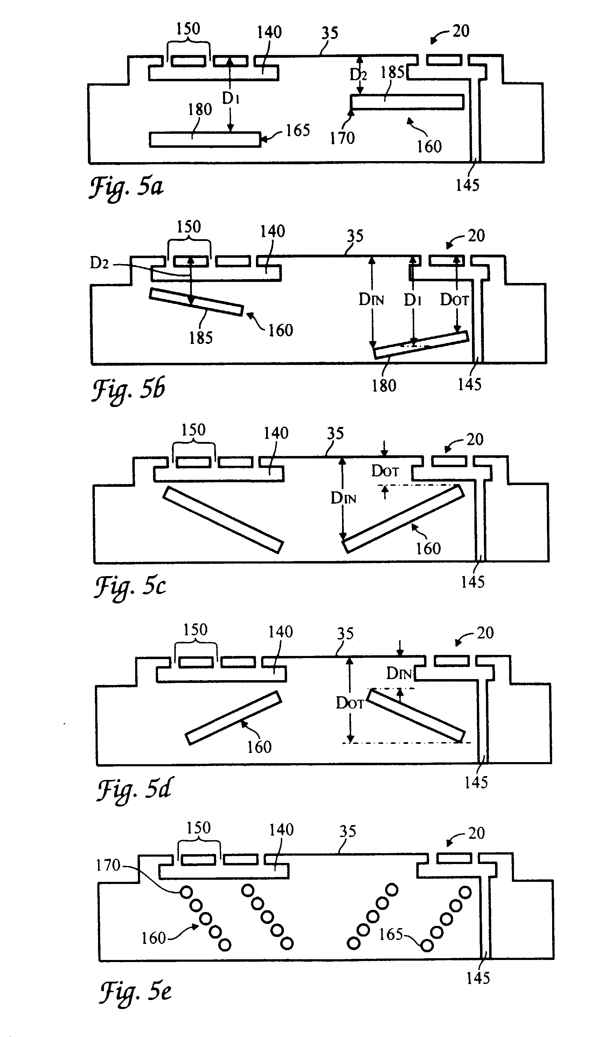

As illustrated in Figure 5a, preferably, the fluid conduit **160** in the body of the electrostatic chuck **20** comprises first passageways **180** at a first distance D₁ from the receiving surface **35** and second passageways **185** at a second distance D₂ from the receiving surface. The difference ΔD between the distances D₁ and D₂ is selected to provide a uniform heat transfer rate from the receiving surface **35** to the conduit **160**, even though the fluid is being heated or cooled by the electrostatic chuck **20** as it travels through the electrostatic chuck. The distance D₁ is sufficiently greater or smaller than the distance D₂ to compensate for the change in temperature of the fluid as it flows through the electrostatic chuck **20**. In other words, the distance D₁ is sufficiently greater or smaller than the distance D₂ to compensate for any difference in temperature ΔT of the fluid that would otherwise cause dissimilar rates of heat transfer from different portions of the receiving surface **35**. In one embodiment, shown in Figure 5a, first passageways **180** are positioned adjacent to the fluid inlet **165**, while second passageways **185** are positioned adjacent to the fluid outlet **170** closer to the receiving surface **35**. This arrangement compensates for the large difference in temperature ΔT between the receiving surface 35 and the fluid entering the body of the chuck **20** than the temperature difference between the receiving surface **35** and fluid exiting the chuck **20**. To maintain substantially uniform temperatures at the receiving surface of the chuck **20**, the fluid inlet **165** is positioned further away from the receiving surface **35** than the fluid outlet **170**. For example, one arrangement shown in Figure 5a comprises a fluid conduit **160** that is shaped as a helical conduit that rises toward the receiving surface **35** as it proceeds from the fluid inlet **165** to the fluid outlet **170**, with the distance D₁ being sufficiently greater than the distance D₂ to provide uniform rates of thermal transfer across the receiving surface **35**.

The fluid conduit **160** with the first and second passageways **180, 185** provides more precise control of the temperature of the substrate **40** by compensating for variations in heat generation or heat conductance across the electrostatic chuck **20**, which is a particular problem for ceramic chucks that contain different materials or internal structures, such as electrodes, channels and conduits which have different thermal impedances. The first and second passageways **180, 185** can comprise any suitable structure for forming a continuous conduit **160** through the electrostatic chuck **20**, as apparent to one of ordinary skill in the art, that will provide the desired differential or uniformity in temperatures across the receiving surface **35**. For example, the fluid conduit **160** can include discrete segments having polyhedra or rectangular shaped cross-sections below the receiving surface **35**, segments that are positioned at an acute or obtuse angle relative to the receiving surface, or a continuous conduit which ascends helically from a perimetric portion to a central portion of the electrostatic chuck **20**, or vice-versa.

In another embodiment of the chuck **20,** the temperature profile across the substrate **40** held on the receiving surface **35** is further controlled by controlling the difference between the distance D_{IN} which is the distance between the receiving surface **35** and the radially inner portion of the fluid conduit **160**, and the distance D_{OT} which is the distance between the receiving surface **35** and the radially outer or perimetric portion of the fluid conduit. The difference in the distances D_{IN} and D_{OT} is selected based on the difference in equilibrium temperatures at the receiving surface **35**, and can be used to design a fluid conduit **160** in conjunction with the distances D₁ and D₂, or independently. For example, Figure 5b shows a conduit where both the distances D_{IN} and D_{OT} and the distances D₁ and D₂ were tailored to achieve a uniform temperature across the receiving surface **35** and the substrate **40**. Figures 5c and 5e illustrate additional fluid conduits **160** comprising an outer circumferential diameter D_{OT} at the perimeter of the electrostatic chuck **20** that is closer to the receiving surface **35** than an inner circumferential diameter D_{IN} near the center of the electrostatic chuck. This arrangement of the fluid conduit **160** provides increased heat transfer from the peripheral portion of the electrostatic chuck **20**, and is useful when the peripheral portion operates at hotter steady state or equilibrium temperatures than the central portion, so that the cooling fluid can cool the peripheral portion at higher cooling rates than the center. Alternatively, when the central portion of the electrostatic chuck **20** is hotter than the peripheral portion, the fluid conduit **160** has the shape shown in Figure 5d, where the inner circumferential diameter D_{IN} near the center of the electrostatic chuck is closer to the receiving surface **35** than the outer circumferential diameter D_{OT}, and the distance D_{IN} is less than the distance D_{OT}.

In one preferred embodiment, the fluid conduit **160** comprises an annular ring that extends circumferentially through the electrostatic chuck **20** and has a rectangular cross-section with a central axis inclined to the plane of the receiving surface **35**, as shown in Figures 5b through 5d. The angular orientation of the annular ring relative to the receiving surface **35** is selected to maintain a substantially uniform temperature across the receiving surface **35** from the perimeter to the center. The annular ring has an inner circumferential edge at a distance D_{IN} from the receiving surface **35,** and an outer circumferential edge at a distance D_{OT} from the receiving surface **35**. In another version shown in Figure 5e, the fluid conduit **160** comprises one or more passages having a circular cross-section that form an ascending spiral about a central vertical axis of the electrostatic chuck **20**. Other equivalent fluid conduit structures and configurations, as apparent to one of ordinary skill in the art, are also within the scope of the present invention.

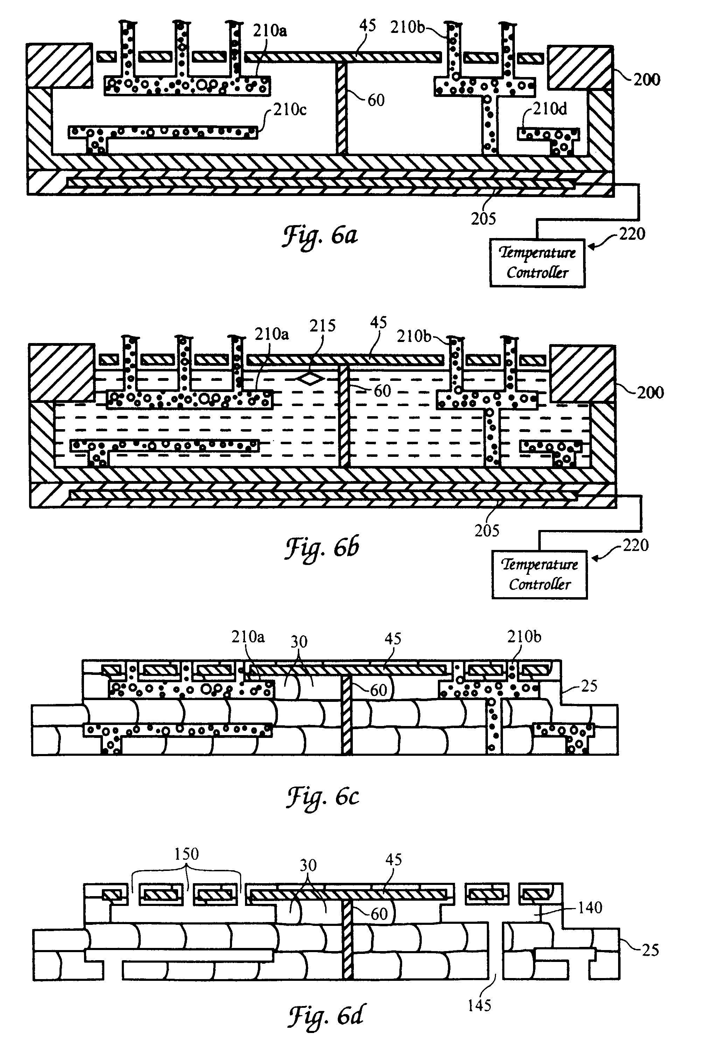

One method of fabricating the electrostatic chuck **20** comprises a melt forming and seeding process that produces a unitary structure of large crystals **30** with an electrode **45** embedded therein. The melt process uses an apparatus comprising a heated mold **200** for melting a ceramic material for forming a molten ceramic, as shown in Figure 6a. The sidewalls of the heated mold **200** are heated by a conventional heater **205**, extending through or wrapped around the mold. The mold **200** is preferably fabricated from a material that uniformly wets the molten ceramic material, and, because the molten ceramic should not be contaminated by dissolution of mold material, is chemically stable with a high melting point. For fabricating electrostatic chucks **20** composed of sapphire, the mold **200** is preferably made of a material such as molybdenum, which has a melting point of 2617°C, uniformly wets molten alumina, and has a low reactivity and high chemical compatibility with molten alumina. Cooling tubes (not shown) containing a heat transfer fluid, such as water or helium gas, can also be provided around the mold to provide a controlled source of heat dissipation.

One or more chemically degradable forms **210a-d** which are shaped to form the gas channel **140**, gas feed **145**, gas vents **150**, and fluid conduit **160** in the electrostatic chuck **20**. The chemically degradable forms **210a-d** and the electrode **45** or bipolar electrodes **45a, 45b** of the electrostatic chuck **20** are held suspended in the molten ceramic material by fine alumina fibers or supported by alumina blocks.

During solidification of the molten ceramic in the mold **200**, a seeding crystal **215** is contacted against the surface of the molten ceramic to seed or nucleate growth of a monocrystalline ceramic in the molten ceramic material. The seeding crystal **215** typically comprises a crystal that has the same composition as the molten ceramic material. Because the seeding crystal **215** has an oriented crystallographic structure it serves as a seeding or nucleating surface that initiates growth of a monocrystalline ceramic structure. The surface of the molten ceramic is then slowly cooled while the sidewalls and bottom of the mold **200** are continuously heated by the heater **205**. This allows the molten ceramic to directionally solidify and grow outwardly from the seeding crystal **215,** to form a monocrystalline structure that is conformal and confined to the internal shape of the mold **200**. The temperature of the mold **200** and the molten ceramic is controlled by a temperature control system **220** that continuously heats the sidewalls and bottom of the mold **200** while the molten ceramic is cooled from the surface toward the bottom of the mold. Slowly reducing the heat applied to the molten material allows the molten ceramic to form large, highly oriented crystals **30**.

After cooling, the solidified ceramic monolith **25** of monocrystalline ceramic material is removed from the mold **200** and treated to remove the chemically degradable forms **210a-d**, creating conduits and channels between the ceramic crystals **30** without damaging the electrostatic chuck **20**. The chemically degradable forms **210a-d** are etched by a suitable chemical, such as a bath of strong nitric acid, in which the ceramic monolith **25** is immersed for about 24 hours. Alternatively, chemically degradable forms **210a-d** can be made of a material, such as graphite, that is removed through oxidation by simply heating the ceramic monolith **25** to a high temperature of about 700°C in an atmosphere containing oxygen for about 120 minutes. When oxidation is used to remove the chemically degradable forms **210a-d**, care should be used to prevent unwanted oxidation of the electrode **45**. For example, when the electrode **45** is made from a refractory metal, the electrode form should be flushed or purged with inert gas to prevent oxidation and cracking of the electrode.

Several different methods can be used to form the electrode **45** in the electrostatic chuck **20**. For example, as illustrated in Figures 6a to 6c, a refractory metal electrode **210c,d** is suspended in the molten ceramic to become embedded in the monocrystalline monolith structure **25**. Suitable electrodes include, for example, an electrode formed from metal foil using conventional bonding, stamping, or pressing methods; metal wire joined together in an interconnected pattern to form a mesh of electrically conductive wire; or a metal plate that is etched to form the desired electrode pattern. Alternatively, the electrode can also be formed by altering the crystalline lattice structure of the monocrystalline ceramic monolith **25** in a predefined pattern to form a conductive electrode pattern on the crystal structure. In this method, lattice defects are introduced in the monocrystalline ceramic using a laser focused inside the ceramic monolith **25**. Suitable laser methods can use a Nd YAG laser having an intensity of 10⁸ Watts/cm² that is scanned across the monocrystalline ceramic to form electrically conducting lattice defects within the monocrystalline ceramic. The lattice defects typically comprise dislocations, which occur when atoms are moved from their initial crystalline positions to interstitial or other lattice sites. In yet another method, the electrode **45** is formed by doping the ceramic monolith **25** with suitable dopants to provide the desired electrical properties such as resistivity and dielectric breakdown strength. For example, a sapphire monocrystalline ceramic material can be doped with 0.1 to 5 wt% TiO₂, in a conductive pattern suitable for use as an electrode **45**. Conventional photolithographic and ion implantation methods can also be used to form a patterned layer of dopant on a sapphire layer.

Another version of the electrostatic chuck **20** comprises a plurality of monocrystalline ceramic plates **225** bonded to one another to form the body of the electrostatic chuck, as shown in Figure 2b. The electrode **45** is embedded in the electrostatic chuck **20**, and the electrical connector **50** extends through one or more monocrystalline ceramic plates **225** to supply a voltage to the electrode. Typically, the monocrystalline ceramic plates **225** comprise a thickness of about 0.1 to 1 cms, and more preferably 0.1 to 0.25 cms (0.04 to 0.10 inches) with a plurality of bonding regions between the monocrystalline ceramic plates that typically have a thickness of about .0001 to.0050 inches. The ceramic monolith **25** comprises from about 2 to about 30 monocrystalline ceramic plates **225**. One or more of the monocrystalline ceramic plates **225** have machined therein (i) the gas channel **140**, (ii) the gas feed **145**, and (iii) gas vents **150** to provide heat transfer gas to the receiving surface **35** below the substrate **40**. The monocrystalline ceramic plates **225** can also have machined therein fluid conduit **160**, fluid inlet **165**, and fluid outlet **170**. The monocrystalline ceramic plates **225** are aligned to one another so that the gas channels **140**, gas feeds **145**, and gas vents **150** form a continuos gas distribution path; and the fluid conduit **160**, fluid inlet **165**, and fluid outlet **170** form a separate continuos fluid path in the electrostatic chuck **20**.

The method of fabricating an electrostatic chuck **20** which comprises a plurality of monocrystalline ceramic plates **225**, illustrated in Figures 5a to 5c, will now be described. Conventional crystal growth techniques, such as the Czochralski or EFG methods, in which a single crystal of ceramic is seeded from molten ceramic, are used to grow a large diameter single crystal of monocrystalline ceramic. The single crystal of monocrystalline ceramic is cut into a number of monocrystalline ceramic plates **225** comprising large aluminum oxide crystals **30** substantially oriented with respect to one another. An electrode **45** comprising a metal structure, a dopant pattern, or a pattern of lattice defects is formed on one or more of the monocrystalline ceramic plates **225**, as described above. The monocrystalline ceramic plates **225** are bonded to one another to form a ceramic monolith **25** using a eutectic bonding compound **230** comprising mixture of aluminum oxide and a eutectic component. The bonding compound **230** is selected to provide an aluminum oxide-containing bond which matches the thermal expansion coefficient of the monocrystalline ceramic plates **225**, yet melts at a relatively low temperature. By eutectic component it is meant an additive, or mixture of additives, that form an eutectic or glassy system with aluminum oxide that has a melting temperature that is significantly lower than that of pure aluminum oxide, preferably less than about 2000°C, and more preferably less than about 1550°C. Preferred eutectic components include for example B₂O₃, P₂O₅, and SiO₂.

Several different methods can be used to form a metal electrode **45** on one of the monocrystalline ceramic plates **225**. In one method, a patterned layer of resist is formed on one of the monocrystalline ceramic plates **225**, and metal deposited between the resist features (for example, by electroplating or sputtering) to form an electrode **45** structure. Suitable resist materials include "RISTON" fabricated by DuPont de Nemours Chemical Co, and conventional photolithographic methods are described in Silicon Processing for the VLSI Era, Volume 1: Process Technology, Chapters 12, 13, and 14, by Stanley Wolf and Richard N. Tauber, Lattice Press, California (1986), which is incorporated herein by reference. Alternatively, the electrode **45** can be fabricated by etching a layer of metal deposited on a sapphire plate using conventional PVD, CVD, or solution deposition methods, such as for example metal CVD or sputtering. Conventional photolithographic and etching methods are used to etch the deposited metal into the desired electrode configuration. The electrode **45** can also be formed on a wafer of monocrystalline ceramic material cut from a column of monocrystalline ceramic by altering the lattice structure of the ceramic wafer in a predefined pattern to form a conductive electrode pattern, or by doping the monocrystalline ceramic with suitable dopants to provide the desired electrical properties such as resistivity and dielectric breakdown strength.

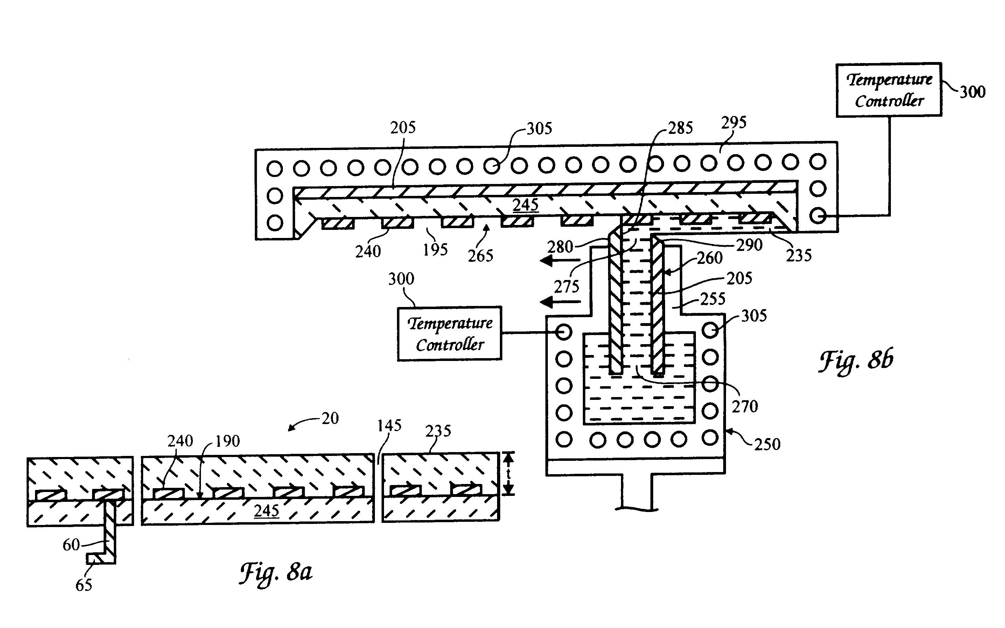

Yet another version of an electrostatic chuck **20** according to the present invention, shown in Figure 8a, comprises a monocrystalline ceramic layer **235** covering a mesh electrode **240** on an underlying dielectric layer **245**, the mesh electrode having predefined apertures **195** therethrough. The underlying dielectric layer **245** can be formed from the same material as the monocrystalline ceramic layer **235** or can be a different ceramic material. The mesh electrode **240** is an electrically conductive patterned electrode. Suitable materials for the monocrystalline ceramic layer and the underlying dielectric layer **245** include Al₂O₃, BeO, SiO₂, Ta₂O₅, ZrO₂, CaO, MgO, TiO₂, BaTiO₃, AIN, TiN, BN, Si₃N₄, ZrB₂, TiB₂, VB₂, W₂B₃, LaB₆, MoSi₂, WSiₓ, or TiSiₓ. Preferably, both the monocrystalline ceramic layer 235 and the underlying dielectric layer **245** comprise sapphire. More preferably, the thickness t of the monocrystalline ceramic layer **235** is at least about three times the diameter of the apertures **195** between the patterned mesh electrode **240** to reduce spreading of the electric field from the electrode.

Preferably, the monocrystalline ceramic layer **235** further comprises integral bonding interconnects **190** that extend through the apertures **195** in the mesh electrode **240** to form a unitary structure with the underlying dielectric layer **245**. The integral bonding interconnects **190** comprise posts of monocrystalline material having large oriented crystals **30** that bond directly to the underlying dielectric layer **245** substantially without adhesive. The posts are formed when molten ceramic material is applied over the exposed surface of the mesh electrode **240**. The molten material seeps into the apertures **195** of the mesh electrode **240** and fuses with the underlying dielectric layer **245** to form a continuous and chemically bonded ceramic structure enclosing the entire mesh electrode. Preferably, the apertures **195** in the mesh electrode **240** are sized sufficiently small to allow the mesh electrode to generate a uniform electrostatic field for holding the substrate **40** upon application of a voltage thereto, and sufficiently large to allow the integral bonding interconnects **190** formed therein to securely bond the monocrystalline ceramic layer **235** to the underlying dielectric layer **245**. Elimination of the adhesive used to join conventional dielectric layers of electrostatic chucks **20**, through use of the integral bonding interconnects **190**, provides more stable and reliable electrical properties at high operating temperatures, exceeding about 1000°C, and often exceeding 2000°C. Elimination of the adhesive also provides improved erosion resistance in highly erosive plasma environments.

The method of fabricating the electrostatic chuck **20** of Figure 8a which comprises a monocrystalline ceramic layer **235**, will now be described. As shown in Figure 8b, the crystal growth apparatus comprises a melt reservoir **250** for melting a ceramic material to form a molten ceramic. The melt reservoir **250** is surrounded by ceramic fiber insulation **255**, and includes a conventional heater **205**, such as tungsten or NICHROME wire, wrapped around the melt reservoir. The melt reservoir **250** is typically made of a corrosion resistant material capable of withstanding the high melting temperatures of the ceramic material, such as molybdenum, which has a melting point of 2617°C. Typical melting temperatures for such ceramic materials often exceed 1000°C, for example, the melting or softening temperature of alumina being 2015°C, of silicon dioxide being from 1200°C to 1700°C, and of titanium dioxide being 1840°C.

A rigid capillary tube **260** is positioned in the molten ceramic of the melt reservoir **250**. The diameter of the capillary tube **260** is selected based on the capillary surface tension forces of the particular ceramic material melted in the reservoir **250**. A typical diameter of the capillary tube **260** is from about 0.2 to about 2 mm. The rigid capillary tube **260** is self-filling due to the capillary forces operating in the capillary tube that draws molten ceramic material up the length of the capillary tube for feeding a molten ceramic layer onto a workpiece surface **265**, such as an exposed surface of one or more mesh electrodes **240**.

The capillary tube **260** comprises an inlet **270** immersed in the molten ceramic in the reservoir, and an outlet **275** adjacent to the workpiece surface **265**, for example, the exposed surface of the electrode. The outlet **275** has (1) a leading edge **280** having a first height and a seeding surface **285**, and (2) a trailing edge **290** having a second height smaller than the first height. The thickness *t* of the monocrystalline ceramic layer **235** deposited on the workpiece surface **265** is controlled by the difference in height of the leading and trailing edges **280, 290** of the outlet **275**, *i.e.,* the difference in first and second heights. The outlet **275** of the capillary tube **260** is moved across the workpiece surface **265** in a direction such that leading edge **280** of the capillary tube **260** moves ahead of the trailing edge **290**, to deposit on the workpiece surface a layer of molten ceramic layer. The molten ceramic layer is drawn through the capillary tube **260** by capillary forces and is seeded by the seeding surface **285** of the leading edge **280** to form a monocrystalline ceramic layer **235** on the workpiece surface **265**.

The integral bonding interconnects **190** are formed during deposition of the molten ceramic layer on the exposed surface of the electrode of the electrostatic chuck **20**, the molten ceramic material flows thorough the apertures **195** in the mesh electrode **240** to bond directly to junction regions on the underlying dielectric layer **245** that lying immediately below the open apertures **195** of the mesh electrode. The resultant structure eliminates the use of adhesives for bonding the underlying dielectric layer **245** below the electrode to the monocrystalline ceramic layer **235** covering the electrode.

Preferably, the temperature of the capillary tube **260** and the workpiece surface **265** is maintained uniform by a temperature control system, which heats the capillary tube and workpiece surface during deposition of the monocrystalline ceramic layer **235**. Heating of the workpiece surface **265** allows the coplanar ceramic layers to merge and flow into one another to form a continuous ceramic layer covering the substantially the entire workpiece surface. The temperature control system comprises a heat shield, a heating and/or a cooling system, and a temperature controller **300**. The heat shield can comprise a cylinder of ceramic fiber insulation **255** surrounding the capillary tube **260**, and a box of ceramic fiber insulation **295** surrounding the workpiece surface **265**, suitable ceramic insulation including ZIRCAR fibers, commercially available from ZIRCAR Company. Preferably, the heat coil in the ceramic insulator is connected to a closed loop temperature controller **300** to control the temperature of the tube and workpiece surface **265**. Cooling tubes **305** that contain a heat transfer fluid, such as water or helium gas, can also be provided around the capillary tube **260** and the workpiece surface **265** to provide a source of rapid heat dissipation (not shown). The rate of growth of the monocrystalline ceramic layer **235** is maximized by reducing heat loss and minimizing thermal shocking of the deposited layer through use of the temperature control system.

The capillary tube **260** is preferably fabricated from a material that is chemically stable, has a high melting temperature, and uniformly wets the molten ceramic material with a contact angle of less than about 90°. A suitable high temperature material is molybdenum. Molybdenum also uniformly wets molten alumina, and has a low reactivity and high chemical compatibility with molten alumina.

The larger the height of the capillary tube **260**, the less the mechanical instabilities and perturbations formed in the molten ceramic layer deposited on the workpiece surface **265**. However, the maximum permissible height of the capillary tube **260** depends on the surface tension and density of the molten ceramic material in the capillary tube. Most ceramic materials have a high surface tension, a low contact angle, and low density, which provides relatively tall capillary rise. A suitable height of the capillary tube **260** for molten alumina in a molybdenum capillary tube is at least about 25 mm, and more preferably at least about 50 mm above the melt surface in the melt reservoir **250**.

The outlet **275** of the capillary tube **260** comprises a leading edge **280** having a seeding surface **285**. The seeding surface **285** seeds or nucleates growth of a monocrystalline ceramic layer **235** from the molten ceramic material. The seeding surface **285** typically comprises a seeding crystal **215** of the same material as the monocrystalline ceramic material, and serves as a seeding or nucleating surface that initiates growth of a monocrystalline ceramic layer **235** on the workpiece surface **265**.

The outlet **275** of the capillary tube **260** does not need to match the shape of the area to be covered by the monocrystalline ceramic layer **235**, because the outlet deposits a ribbon of molten ceramic material on the workpiece surface **265** as the outlet moves across the workpiece surface. The workpiece surface **265** is continuously heated during deposition of multiple ribbons of ceramic material, to a temperature close to the melting temperature of the ceramic material deposited thereon, causing the ribbons to flow into one another to form a ceramic layer that is continuous and uniform across the workpiece surface **265**. The width of each ribbon of molten ceramic corresponds to the width *w* of the outlet **275**, and the height *t* of the ribbons corresponds to the difference in height of the leading and trailing edges **280, 290**, that define the outlet opening.

The capillary tube **260** and workpiece surface **265** are moved relative to one another to deposit a uniform layer of molten ceramic material on the electrode. Typically, the rate of movement of the molten ceramic material through the capillary tube **260** is from about 10 to 100 cm/min; and the rate of movement of the outlet **275** of the capillary tube is adjusted accordingly to provide the desired thickness *t* of the monocrystalline ceramic material on the workpiece surface **265**. Preferably, the workpiece surface **265** is moved across the outlet **275** of the capillary tube **260** at a rate sufficiently low to provide a melt interface that is mechanically stable. Since the capillary tube **260** is fixed in the melt reservoir **250**, the top of the molten ceramic material in the tube and the crystal growth interface are both relatively stationary with respect to the melt reservoir. Alternatively, the outlet **275** of the capillary tube **260** along with the surrounding heat shield, is moved across the workpiece surface **265**. Multiple layers of monocrystalline ceramic material, stacked onto top of one another, can be deposited on the workpiece surface **265**.

While the present invention has been described in considerable detail with reference to certain preferred versions, many other versions should be apparent to those of ordinary skill in the art. For example, the monocrystalline ceramic can be fabricated by grain growth of polycrystalline ceramic material or by other suitable melt forming methods. Also, the electrode and other shapes can be formed by other methods, for example, by drilling or machining a monocrystalline ceramic and inserting the desired shapes and forms. Therefore, the scope of the appended claims should not be limited to the description of the preferred versions contained herein.

## Claims

1. An electrostatic chuck composed of monocrystalline ceramic having a receiving surface for receiving the substrate, an electrode embedded in the monocrystalline ceramic, and an electrical connector extending through the monocrystalline ceramic for supplying a voltage to the electrode for electrostatically holding a substrate in a process chamber.

2. An electrostatic chuck according to claim 1 characterized in that the monocrystalline ceramic comprises a monolith of large crystals having a diameter of from 0.5 to 10 cm, the crystals being oriented in substantially a single crystallographic direction.

3. An electrostatic chuck according to claim 2 characterized in that the monocrystalline ceramic comprises one or more of Al₂O₃, AIN, BaTiO₃, BeO, BN, CaO, LaB₆, MgO, MoSi₂, Si₃N₄, SiO₂, Ta₂O₅, TiB₂, TiN, TiO₂, TiSi_{2,} VB₂, W₂B₃, WSi₂, ZrB₂, or ZrO₂; and the electrode comprises one of (i) refractory metal having a melting point of at least about 2200°C, (ii) a pattern of dopant in a monocrystalline ceramic plate, or (iii) a pattern of lattice defects in a monocrystalline ceramic plate.

4. An electrostatic chuck according to claim 3 characterized in that the monocrystalline ceramic consists essentially of sapphire.

5. An electrostatic chuck according to claim 4 characterized in that the monocrystalline ceramic comprises at least one of (i) a unitary monolithic structure, or (ii) a plurality of monocrystalline ceramic plates bonded to one another.

6. An electrostatic chuck according to claim 5 characterized in that the monocrystalline ceramic plates are bonded by a bonding compound comprising an eutectic mixture of aluminum oxide and eutectic component, the eutectic mixture having a melting temperature of less than about 2000°C.

7. An electrostatic chuck according to claim 5 characterized in that one or more of the monocrystalline ceramic plates comprise grooves and holes that cooperate to define (i) a gas channel for holding heat transfer gas, (ii) a gas feed for providing heat transfer gas to the gas channel, and (iii) gas vents extending from the gas channel to the receiving surface for providing heat transfer gas below the substrate.

8. An electrostatic chuck according to claim 1 further comprising a fluid conduit for circulating heat transfer fluid therethrough, the fluid conduit comprising at least one of the following characteristics:
(1) a cross-section having a central axis that is at an angle to the receiving surface;
(2) a conduit rising toward the receiving surface from the fluid inlet to the fluid outlet;
(3) first passageways at a distance D₁ from the receiving surface and second passageways at a distance D₂ from the receiving surface, the distance D₁ being greater than the distance D₂;
(4) first passageways adjacent to the fluid inlet and the second passageways adjacent to the fluid outlet; or
(5) circumferential inner and outer edges, the inner edge being at a distance D_{IN} from the receiving surface, and the outer edge being at a distance D_{OT} from the receiving surface, the difference between the distance D_{IN} and the distance D_{OT} selected to maintain a substantially uniform rate of thermal transfer across the receiving surface of the chuck.

9. A method of fabricating an electrostatic chuck, the method comprising the steps of:
(a) melting ceramic material in a mold to form a molten ceramic, the mold having an internal shape of an electrostatic chuck;
(b) holding one or more of electrode forms, channel forms, or conduit forms in the molten ceramic;
(c) maintaining a seeding crystal in contact with the molten ceramic;
(d) cooling the molten ceramic to form monocrystalline ceramic comprising large crystals substantially oriented to one another, and having the electrode, channel, or conduit forms embedded therein; and
(e) treating one or more of the electrode, channel, or conduit forms to form a monocrystalline ceramic monolith having an electrode, channel, or conduit therein.

10. A method according to claim 9 characterized in that the electrode forms are composed of refractory metal, and the conduit and channel forms are made from chemically degradable material that can be etched away or an oxidizable material that can be oxidized without damaging the surrounding monocrystalline ceramic.

11. A method of forming a monocrystalline electrostatic chuck, the method comprising the steps of:
(a) forming a plurality of monocrystalline ceramic plates comprising large crystals having a diameter from 0.5 to 10 cm, the large crystals being oriented in substantially a single crystallographic direction;
(b) forming an electrode between or on the monocrystalline ceramic plates; and
(c) bonding the monocrystalline ceramic plates to one another to form a monocrystalline ceramic monolith having an embedded electrode with an electrical connector extending out of the monocrystalline ceramic monolith.

12. A method according to claim 11 characterized in that the monocrystalline ceramic plates are made from sapphire, and are bonded to one another by applying to the monocrystalline ceramic plates, a bonding compound comprising an eutectic mixture of aluminum oxide and eutectic component, the eutectic mixture having an melting temperature of less than about 2000°C, and heat treating the bonding compound.

13. A method according to claim 11 characterized in that the electrode is formed by at least one of the following steps:
(i) attaching a mesh electrode to a monocrystalline ceramic plate;
(ii) depositing a metal layer on a monocrystalline ceramic plate and etching the deposited metal layer; or
(iii) forming a pattern of resist features on a monocrystalline ceramic plate and depositing metal between the resist features.

14. A method according to claim 13 characterized in that the electrode comprises a refractory metal having a melting point of at least about 2200°C.

15. A method according to claim 14 characterized in that the electrode comprises a mesh electrode having apertures sized sufficiently small that the electrode can electrostatically securely hold a substrate, and sufficiently large to allow bonding compound in the apertures to securely bond the monocrystalline ceramic plates to one another.

16. An electrostatic chuck for holding a substrate in a process chamber, the electrostatic chuck comprising:
(a) a dielectric member having an electrode embedded therein and a receiving surface for receiving the substrate; and
(b) a fluid conduit for circulating heat transfer fluid in the dielectric.

17. An electrostatic chuck according to claim 16 in which the fluid conduit comprises at least one of the following characteristics:
(1) a cross-section having a central axis that is at an angle to the receiving surface;
(2) a conduit rising toward the receiving surface from the fluid inlet to the fluid outlet;
(3) first passageways at a distance D₁ from the receiving surface and second passageways at a distance D₂ from the receiving surface, the distance D₁ being greater than the distance D₂;
(4) first passageways adjacent to the fluid inlet and the second passageways adjacent to the fluid outlet; or
(5) circumferential inner and outer edges, the inner edge being at a distance D_{IN} from the receiving surface, and the outer edge being at a distance D_{OT} from the receiving surface, the difference between the distance D_{IN} and the distance D_{OT} being selected to maintain a substantially uniform rate of thermal transfer across the receiving surface of the chuck.

18. An electrostatic chuck according to claim 17 characterized in that the first distance D₁ is sufficiently greater than the second distance D₂ to compensate for a rise in temperature of the heat transfer fluid as it flows through the conduit during operation of the chuck in a process chamber.

19. A method of regulating the temperature of a substrate held on a surface of a support, the method comprising the steps of supplying heat transfer fluid through first passageways that are at a distance D₁ from the receiving surface, and removing the heat transfer fluid from second passageways that are at a distance D₂ from the receiving surface, the distance D₁ being greater than the distance D₂.

20. A method according to claim 19 characterized in that the distance D₁ is sufficiently greater than the distance D₂ to compensate for a rise in temperature of the heat transfer fluid in the conduit that occurs as the heat transfer fluid flows through conduit.

21. A dielectric member for supporting a substrate in a process chamber, the dielectric member comprising a receiving surface for receiving the substrate, and a fluid conduit embedded in the dielectric member for circulating heat transfer fluid below the receiving surface.

22. The dielectric member of claim 21 characterized in that the fluid conduit comprises at least one of the following characteristics:
(1) a cross-section having a central axis that is at an angle to the receiving surface;
(2) a conduit rising toward the receiving surface from the fluid inlet to the fluid outlet;
(3) first passageways at a distance D₁ from the receiving surface and second passageways at a distance D₂ from the receiving surface, the distance D₁ being greater than the distance D₂;
(4) first passageways adjacent to the fluid inlet and the second passageways adjacent to the fluid outlet; or
(5) circumferential inner and outer edges, the inner edge being at a distance D_{IN} from the receiving surface, and the outer edge being at a distance D_{OT} from the receiving surface, the difference between the distance D_{IN} and the distance D_{OT} being selected to maintain a substantially uniform rate of thermal transfer across the receiving surface of the chuck.

23. An electrostatic chuck for holding a substrate in a process chamber, the electrostatic chuck comprising a monocrystalline ceramic layer covering a mesh electrode on an underlying dielectric layer, the monocrystalline ceramic layer comprising large crystals substantially oriented to one another, and having integral bonding interconnects that extend through apertures in the mesh electrode to bond directly to the underlying dielectric layer.

24. An electrostatic chuck according to claim 23 characterized in that the monocrystalline ceramic layer is bonded directly to the underlying dielectric layer substantially without adhesive.

25. An electrostatic chuck according to claim 24 characterized in that one or more of the monocrystalline ceramic layer or the underlying dielectric layer is composed of sapphire.

26. A method of forming a monocrystalline ceramic layer on a workpiece surface, the method comprising the steps of:
(a) melting a ceramic in a melt reservoir to form a molten ceramic;
(b) positioning a capillary tube in the molten ceramic of the melt reservoir, the capillary tube comprising an inlet in the reservoir and an outlet adjacent to the workpiece surface, the outlet comprising a leading edge having a first height and a seeding surface, and a trailing edge having a second height smaller than the first height;
(c) moving the outlet of the capillary tube across the workpiece surface so that the leading edge moves ahead of the trailing edge to deposit on the workpiece surface, a molten ceramic layer that is drawn through the capillary tube, seeded by the seeding surface of the leading edge, and has a thickness *t* substantially controlled by the difference in first and second heights; and
(d) cooling the seeded molten ceramic layer to form a monocrystalline ceramic layer comprising large crystals substantially oriented to one another.

27. A method according to claim 26 characterized in that the seeding surface on the leading edge comprises a seeding crystal of the monocrystalline ceramic, and the workpiece surface is continuously heated during deposition of the monocrystalline ceramic layer.
